# EUROPÄISCHE PATENTSCHRIFT

(11) **EP 3 082 001 B1**
(45) Veröffentlichungstag und Bekanntmachung des Hinweises auf die Patenterteilung: **09.09.2020**
(21) Anmeldenummer: 15163409.4
(22) Anmeldetag: 13.04.2015
(51) Int. Cl.: H04L 12/26

(54) **VERFAHREN ZUM ERWEITERN EINER AUTOMATISIERUNGSEINRICHTUNG MITTELS EINEM VIRTUELLEN FELDGERÄT SOWIE AUTOMATISIERUNGSEINRICHTUNG**
METHOD FOR EXPANDING AN AUTOMATION DEVICE USING A VIRTUAL FIELD DEVICE AND AUTOMATION DEVICE
PROCÉDÉ D'EXTENSION D'UN DISPOSITIF D'AUTOMATISATION AVEC UN VIRTUEL APPAREIL D'AUTOMATISATION ET DISPOSITIF D'AUTOMATISATION

(43) Veröffentlichungstag der Anmeldung: 19.10.2016
(73) Patentinhaber: Siemens Aktiengesellschaft, 80333 München (DE)
(72) Erfinder: Drumm, Oliver, Dr., 76344 Eggenstein-Leopoldshafen (DE); Heck, Christian, 75196 Remchingen (DE); Kraus, Rolf, 76287 Rheinstetten (DE); Lutz, Benjamin, Dr., 76327 Pfinztal (DE); Wolf, Gerrit, 76187 Karlsruhe (DE)

(56) Entgegenhaltungen:
- DE-A1- 10 245 176
- DE-A1-102007 062 395
- DE-A1-102010 029 952
- DE-A1-102010 053 485

## Beschreibung

Die Erfindung betrifft ein Verfahren zum Erweitern einer Automatisierungseinrichtung mit einem Feldgerät, wobei die Automatisierungseinrichtung zumindest ein Automatisierungsgerät und zumindest ein Feldgerät aufweist, die an eine Kommunikationsverbindung angeschlossen sind, und wobei die Automatisierungseinrichtung ferner durch ein Engineeringverfahren zur Lösung einer Automatisierungsaufgabe derart projektiert ist, dass das zumindest eine Automatisierungsgerät während einer Prozesssteuerung ein projektiertes Steuerprogramm verarbeitet, das eine Vielzahl von Steuer-Bausteinen umfasst. Darüber hinaus betrifft die Erfindung eine Automatisierungseinrichtung gemäß dem Oberbegriff des Anspruchs 3 zur Durchführung des Verfahrens.

Aus dem Siemens-Katalog "Prozessleitsystem SIMATIC PCS 7, Ausgabe 2014/15, Kapitel 4, ist ein Engineering-System einer Automatisierungseinrichtung bekannt, das dazu ausgebildet ist, sowohl Hardware- als auch Software-Automatisierungskomponenten der Automatisierungseinrichtung zu projektieren, wobei insbesondere im Rahmen eines "Engineering der Automatisierung" ein Anwender ein Steuerprogramm zur Steuerung eines technischen Prozesses bzw. einer zu steuernden Anlage erstellt bzw. projektiert.
Eine derartige Anlage ist gewöhnlich keine statische Produktionsstätte, die einmal geplant, errichtet und in Betrieb genommen und anschließend nicht mehr verändert wird. Vielmehr unterliegt die Anlage ständigen Änderungen und Anpassungen, um die Produktion zu optimieren und zu erweitern. Dazu ist es gewöhnlich erforderlich, auch neue prozessnahe Automatisierungskomponenten in Form von weiteren Feldgeräten in die Automatisierungseinrichtung einzubinden. Diese Einbindung erfolgt derart, dass diese Feldgeräte über einen Bus mit dem Automatisierungsgerät bzw. mit einer Steuerung der Automatisierungseinrichtung kommunikativ verbunden werden und das Steuerprogramm bzw. die Automatisierungssoftware mit entsprechenden Steuerbausteinen zum Ansteuern dieser Feldgeräte entsprechend ergänzt wird. Im Rahmen einer derartigen Erweiterung ist es wünschenswert, dass die Produktion - z. B. die Produktion zur Herstellung von Kunstharz, Farbstoffen oder Düngemitteln - nicht störend beeinflusst wird. Dies bedeutet, dass die bereits bestehenden Automatisierungskomponenten der Automatisierungseinrichtung während der Inbetriebsetzung bzw. während der Einbindung der neuen Feldgeräte ohne wesentliche Einschränkung des Produktionsbetriebs weiterlaufen muss; denn jede Einschränkung oder sogar ein Produktionsstopp (Anlagenstillstand) führt gewöhnlich zu finanziellen Einbußen.

Ob die vorhanden Leistungsreserven des Automatisierungsgerätes oder der Kommunikationsverbindung ausreichen, um die neuen Feldgeräte ohne eine derartige Einschränkung in Betrieb setzen zu können, zeigt sich während deren Inbetriebnahme. Nicht selten führt diese Inbetriebnahme zu einem Stillstand der Anlage und damit zu einem Produktionsstopp, weil die Leistungsreserven nicht ausreichen, um Aufgaben zu vorgegebenen Verarbeitungszyklen des Automatisierungsgerätes oder im Rahmen der vorgegebenen Kommunikationszyklen des Kommunikationsnetzes der Automatisierungseinrichtung zu bewerkstelligen.

Um die Störanfälligkeit während der Inbetriebnahme der neuen Feldgeräte zu verringern, können im Rahmen der Projektierung von Erweiterungen der Automatisierungseinrichtung die Leistungsreserven der Steuerung und des Kommunikationsnetzes abgeschätzt werden. Hier spielen neben klaren Fakten, wie die maximale Zahl der Automatisierungskomponenten bzw. Busteilnehmer und der maximale Umfang der Steuerungssoftware bezogen auf die Speicherbelegung und die Verarbeitungslaufzeit bzw. den Verarbeitungszyklus, vor allem auch die langjähre Erfahrung der Projekteure eine bedeutende Rolle. Aufgrund dieser Abschätzungen bzw. Annahmen erfolgt die Inbetriebnahme nie ohne Restrisiko. Dieses Restrisiko kann vermindert werden, indem eine entsprechende "Schatten-Anlage bzw. - Automatisierungseinrichtung" aufgebaut wird, um die Funktionsweise und die Inbetriebnahme vorab zu testen. Dies bedeutet erhebliche Material- und Personalkosten, wobei ferner eine Schatten-Anlage für die Vorbereitung der Erweiterung in der Regel auch nur eine Nachbildung der Anlage und nie eine exakte Kopie repräsentiert.

DE 102 45 176 A1 offenbart ein Verfahren zur Simulation eines Feldgerätes.

Der Erfindung liegt daher die Aufgabe zugrunde, ein Verfahren entsprechend Anspruch 1 auszuführen. Darüber hinaus ist eine Automatisierungseinrichtung entsprechend Anspruch 2 auszuführen. Diese Aufgabe wird im Hinblick auf das Verfahren durch die im kennzeichenenden Teil des Anspruchs 1 angegebenen, bezüglich der Automatisierungseinrichtung durch die im kennzeichnenden Teil des Anspruchs 2 angegebenen Maßnahmen gelöst.

Vorteilhaft ist, dass ein sicherer und stufenweise steigerungsfähiger "Stresstest" für die Erweiterung der Automatisierungseinrichtung möglich ist, wobei auf eine "Schatten-Automatisierungseinrichtung" verzichtet werden kann und sichergestellt ist, dass ein Stillstand der Automatisierungseinrichtung und damit ein Produktionsstopp vermieden wird. Ein Anwender kann mehrere virtuelle Feldgeräte projektieren, die jeweils ein reales Feldgerät repräsentieren sowie diese realen Feldgeräte emulieren. Diese virtuellen Feldgeräte werden nacheinander der Automatisierungseinrichtung zugeschaltet bzw. aktiviert, wobei nach jedem Zuschalten eines der virtuellen Feldgeräte zunächst die aktuelle Kommunikations-Belastung und die aktuelle Steuer-Belastung der Automatisierungseinrichtung erfasst werden. Für den Fall, dass die aktuelle Kommunikations-Belastung eine Kommunikations-Lastgrenze und die aktuelle Steuer-Belastung eine Steuer-Lastgrenze nicht überschreiten, kann der Anwender die Automatisierungseinrichtung schließlich um das reale Feldgerät erweitern, welches durch das zugeschaltete virtuelle Feldgerät emuliert wurde.

Anschließend kann ein weiteres der virtuellen Feldgeräte zugeschaltet werden um wiederum zu prüfen, ob die Automatisierungseinrichtung um ein diesem virtuellen Feldgerät entsprechendes reales Feldgerät erweitert werden kann. Dem Anwender wird stets angezeigt, wie hoch die aktuelle Kommunikationsund Steuer-Belastung ist, sodass die Automatisierungseinrichtung quasi in "homöopathischen Dosen" (durch Hinzufügen jeweils eines weiteren virtuellen Feldgerätes) an die Kommunikations- und Steuer-Lastgrenzen herangeführt werden kann.

Falls allerdings die aktuelle Kommunikations- oder die aktuelle Steuer-Belastung die jeweilige Lastgrenze überschreitet, nachdem ein virtuelles Feldgerät zugeschaltet wurde, ist eine Erweiterung der bestehenden Automatisierungseinrichtung mit dem realen Feldgerät, das durch dieses zugeschaltete virtuelle Feldgerät emuliert wurde, nicht möglich. In diesem Fall muss zunächst die bestehende Automatisierungseinrichtung mit einem oder mehreren Automatisierungsgeräten und/oder Kommunikationsmitteln erweitert werden.

In einer Ausgestaltung der Erfindung wird eine Remotebearbeitung ermöglicht. Dem Anwender wird die aktuelle Kommunikationsund die aktuelle Steuer-Belastung auf einem Bedien- und Beobachtunggerät angezeigt, wobei der Anwender über dieses Gerät den Steuer-Baustein freischalten kann, falls die aktuelle Kommunikations- und die aktuelle Steuer-Belastung die jeweilige Lastgrenze nicht überschreiten.
Anhand der Zeichnung, in der ein Ausführungsbeispiel der Erfindung veranschaulicht ist, werden im Folgenden die Erfindung, deren Ausgestaltungen sowie Vorteile näher erläutert.
Es zeigen in einer vereinfachten Darstellung
Figur 1 Bestandteile einer Automatisierungseinrichtung und
Figur 2 die Anzeige einer Kommunikations- und Steuer-Belastung auf einem Bedien- und Beobachtungsgerät.

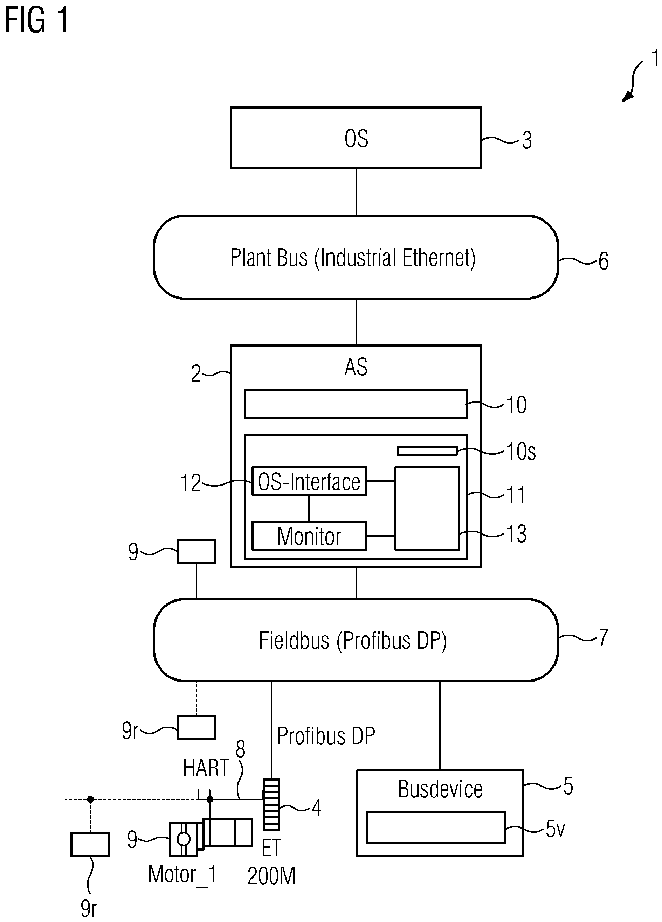

In Figur 1 ist mit 1 eine mittels eines hier nicht dargestellten Engineering-Systems projektierte Automatisierungseinrichtung 1 dargestellt. Diese umfasst im vorliegenden Ausführungsbeispiel ein Automatisierungsgerät 2, einen OS-Client bzw. ein Bedien- und Beobachtungsgerät 3 eines OS-Operator-Systems, das ferner einen hier nicht dargestellten OS-Server aufweist, eine dezentrale Peripherie 4 sowie einen Kommunikationsteilnehmer 5. Das Automatisierungsgerät 2 kommuniziert mit dem OS-Client 3 über eine Kommunikationsverbindung 6 und über eine weitere Kommunikationsverbindung 7 mit der dezentralen Peripherie 4 und einem Kommunikationsteilnehmer 5, wobei die Kommunikationsverbindungen 6, 7 als Busverbindungen ausgebildet sind. Eine Vielzahl von Feldgeräten 9 (Aktoren, Sensoren) ist an den Bus 7 und/oder an einen weiteren mit der dezentralen Peripherie 4 verbundenen Bus 8 angeschlossen, wobei während der Prozesssteuerung, d. h. während des Run-Betriebs des Automatisierungsgerätes 2, die Feldgeräte 9 mittels Steuer-Bausteinen angesteuert werden. Diese Steuer-Bausteine sind Bestandteil eines Steuerprogramms, welches nach Maßgabe einer zu lösenden Automatisierungsaufgabe während eines Engineerings durch ein Engineeringverfahren projektiert bzw. erstellt wird.

Ein an sich bekanntes Engineering bzw. Engineeringverfahren zur Erstellung eines Steuerprogramms basiert auf einem auf dem Engineering-System ablauffähigen Continuous Function Chart (CFC)- und auf Sequential Continuous Function Chart (SFC)-Editoren.
Ein Anwender erstellt mittels des CFC-Editors aus vorgefertigten Bausteinen nach Maßgabe der zu lösenden Automatisierungsaufgabe grafisch das Steuerprogramm für das Automatisierungsgerät 2 und wählt dazu die Bausteine, z. B. einen Regler- oder Zähler-Baustein, aus einem verfügbaren Bausteinvorrat aus, platziert die Bausteine z. B. per Drag&Drop in einem Funktionsplan (z. B. CFC-Plan) und verschaltet diese per Mausklick miteinander. Nachdem der Anwender alle Funktionen im Funktionsplan erstellt hat, erzeugt das Engineering-System durch das Automatisierungsgerät 2 lesbare CFC-Funktionen, die in dieses Automatisierungsgerät 2 geladen und dort im Rahmen der Prozesssteuerung zur Lösung der Automatisierungsaufgabe verarbeitet werden.
Mittels des SFC-Editors erstellt der Anwender ferner in gewohnter Art und Weise grafisch eine Ablaufsteuerung (SCF), die gewöhnlich eine Vielzahl von Schrittketten umfasst, die wiederum eine Vielzahl von Rezeptelementen sowie Transitionen aufweisen, z. B. Rezeptelemente in Form von Rezeptoperationen oder Rezeptfunktionen, z. B. Dosieren, Heizen oder Rühren. Aus dieser Ablaufsteuerung erzeugt das Engineering-System durch das Automatisierungsgerät 2 verarbeitbare (SFC-) Objekte, die das Engineering-System compiliert und in das Automatisierungsgerät 2 lädt.
Während der Prozesssteuerung - also im RUN-Betrieb des Automatisierungsgeräts 2 - wird die Interaktion und Verknüpfung zwischen den (SFC-) Objekten und den CFC-Funktionen über Prozesswerte und Steuersignale (SFC-Daten) bewerkstelligt, wobei ferner einem Operator die Schrittkette auf dem OS-Client 3 dargestellt wird. Dadurch kann der Operator beobachten, welches Rezeptelement der Schrittketten gerade verarbeitet wird. Jedem Schritt der Schrittkette ist eine bestimmte Aktion zugeordnet, welche die CFC-Funktionen parametrieren und aktivieren, wobei dazu entsprechende Steuersignale gesetzt werden. Die Prozesswerte umfassen Prozesseingangswerte (Istwerte), welche Sensoren dem Automatisierungsgerät 2 zuführen und die das Automatisierungsgerät 2 dem OS-Server zur Hinterlegung in einem Prozessabbild übermittelt, sowie Prozessausgangswerte (Sollwerte), die der OS-Server dem Automatisierungsgerät 2 zur Ansteuerung der Aktoren zuführt.

Im vorliegenden Ausführungsbeispiel wird angenommen, dass im Automatisierungsgerät 2 ein projektiertes Steuerprogramm 10 (SFCs, CFCs) hinterlegt ist und das Automatisierungsgerät 2 dieses Steuerprogramm 10 zur Prozesssteuerung gerade verarbeitet. Um während dieser Prozesssteuerung die Automatisierungseinrichtung 1 um ein oder mehrere reale Feldgeräte 9r - ohne störende Einflüsse auf die Prozesssteuerung - erweitern zu können, sind im Kommunikationsteilnehmer 5 für jedes dieser Feldgeräte 9r ein durch das Engineering-System projektiertes virtuelles Feldgerät 5v und ferner im Automatisierungsgerät 2 ein Erweiterungs-Baustein 11 hinterlegt, welcher für jedes virtuelle Feldgerät 5v einen projektierten Steuer-Baustein 10s zum Ansteuern des jeweiligen virtuellen Feldgerätes 5v aufweist. Diese virtuellen Feldgeräte 5v repräsentieren die realen Feldgeräte und sind dazu ausgebildet, die realen Feldgeräte zu emulieren. Der Erweiterungs-Baustein 11 ist ferner mit einer OS-Schnittstelle 12 zum Austauschen von Informationen zwischen dem Erweiterungs-Baustein 11 und dem OS-Client 3 versehen, wobei einerseits der Anwender durch eine entsprechende Eingabe am OS-Client 3 die Erweiterung der Automatisierungseinrichtung 1 einleiten kann und andererseits der OS-Client 3 dem Anwender die aktuelle Kommunikations- und Steuer-Belastung anzeigt. Darüber hinaus kann der Anwender durch eine weitere Eingabe am OS-Client 3 die jeweiligen Steuer-Bausteine 10s freischalten, damit der Erweiterungs-Baustein 11 in Abhängigkeit der aktuellen Kommunikations- und Steuer-Belastung die jeweiligen Steuer-Bausteine 10s in das Steuerprogramm 10 einbindet.
Die Erweiterung der Automatisierungseinrichtung 1 erfolgt in der Art und Weise, dass ein Anwender zunächst eines der projektierten virtuellen Feldgeräte 5v auswählt, indem er z. B. ein diesem Feldgerät 5v zugeordnetes und auf dem OS-Client 3 dargestelltes Icon anwählt bzw. markiert. Aufgrund dieser Auswahl kommuniziert ein Ausführungsteil 13 des Erweiterungs-Bausteins 11 mit diesem virtuellen, im Kommunikationsteilnehmer 5 hinterlegten Feldgerät 5v, wobei der Kommunikationsteilnehmer 5 die aktuelle Kommunikations-Belastung ermittelt und abspeichert. Diese Kommunikations-Belastung umfasst die durch die Kommunikation zwischen dem virtuellen Feldgerät 5v und dem Ausführungsteil 13 und die durch die Kommunikation der Prozesssteuerung verursachte Belastung. Unter der Formulierung "durch die Kommunikation der Prozesssteuerung verursachte Belastung" wird die Belastung der Kommunikationsverbindung 7 während der Verarbeitung des Steuerprogramms 10 verstanden, während dessen das Automatisierungsgerät 2 mit den realen Feldgeräten 9 kommuniziert. Dadurch, dass der Kommunikationsteilnehmer 5 die Kommunikations-Belastung erfasst, wird das Automatisierungsgerät 2 nicht zusätzlich belastet. Der Erweiterungs-Baustein 11 liest die im Kommunikationsteilnehmer 5 abgespeicherte aktuelle Kommunikations-Belastung aus und übermittelt diese über die OS-Schnittstelle 12 dem OS-Client 3, welcher die aktuelle Kommunikations-Belastung dem Anwender anzeigt. Für den Fall, dass diese aktuelle Kommunikations-Belastung eine vorgegebene Kommunikations-Lastgrenze erreicht oder überschreitet, wird der Anwender mittels einer Anzeige bzw. Meldung auf dem OS-Client darauf hingewiesen, dass eine Erweiterung der bestehenden Automatisierungseinrichtung 1 mit dem dem virtuellen Feldgerät 5v entsprechenden realen Feldgerät 9r nicht möglich ist, es sei denn, die Automatisierungseinrichtung 1 wird um ein weiteres Kommunikationsmittel (Busverbindungen, Switches, ...) erweitert.
Für den Fall dagegen, dass diese aktuelle Kommunikations-Belastung die vorgegebene Kommunikations-Lastgrenze nicht überschreitet, aktiviert der Ausführungsteil 13 automatisch den Steuer-Baustein 10s zum Ansteuern des ausgewählten virtuellen Feldgerätes 5v. Während dieser Ansteuerung erfasst der Erweiterungs-Bausteins 11 die Steuer-Belastung des Automatisierungsgerätes 2, welche die durch die Prozesssteuerung und die durch die Verarbeitung des Steuer-Bausteins 10s zum Ansteuern des ausgewählten virtuellen Feldgerätes 5v verursachte Belastung umfasst, wobei diese beiden Belastungen sich auf den Verarbeitungszyklus des Automatisierungsgerätes 2 auswirken. Dabei wird unter der Formulierung "die durch die Prozesssteuerung verursachte Belastung" die Belastung des Automatisierungsgerätes 2 während der Verarbeitung des Steuerprogramms 10 verstanden. Zur Anzeige der aktuellen Steuer-Belastung übermittelt der Erweiterungs-Baustein 11 die aktuelle Steuer-Belastung ebenfalls über die OS-Schnittstelle 12 dem OS-Client 3, wodurch dem Anwender neben der aktuellen Kommunikations-Belastung auch die aktuelle Steuer-Belastung der Automatisierungseinrichtung 1 angezeigt wird. Für den Fall, dass diese aktuelle Steuer-Belastung eine vorgegebene Steuer-Lastgrenze nicht erreicht oder überschreitet, bindet der Erweiterungs-Baustein 11 den Steuer-Baustein 10s in das Steuerprogramm 10 ein, falls der Anwender diesen Steuer-Baustein 10s zum Anschließen des realen Feldgerätes 9r an den Bus freischaltet. Die Freischaltung durch den Anwender erfolgt mittels einer geeigneten Eingabe am OS-Client 3, auf welchem dem Anwender neben der aktuellen Steuer-Belastung die Steuer-Lastgrenze angezeigt wird. Nachdem der Anwender den Steuer-Baustein 10s freigeschaltet hat, kann das dem virtuellen Feldgerät 5v entsprechende reale Feldgerät 9r an den Bus 8 angeschlossen werden. Für den Fall, dass die aktuelle Steuer-Belastung allerdings die vorgegebene Steuer-Lastgrenze erreicht oder überschreitet, blockiert der Erweiterungs-Baustein 11 den Steuer-Baustein 10s, was bedeutet, dass dieser nicht in das Steuerprogramm 10 eingebunden wird. Auch in diesem Fall wird dem Anwender angezeigt, dass die bestehende Automatisierungseinrichtung 1 um dieses Feldgerät nicht erweitert werden kann. Eine Erweiterung der Automatisierungseinrichtung ist nur dann möglich, wenn diese um ein weiteres Automatisierungsgerät erweitert wird, wodurch die Steuer-Belastung auf mehrere Automatisierungsgeräte verteilt werden kann.

In der beschrieben Art und Weise kann die Automatisierungseinrichtung 1 um weitere Feldgeräte erweitert werden. Dazu wird zunächst ein weiteres der virtuellen Feldgeräte zugeschaltet und wiederum geprüft, ob die Automatisierungseinrichtung 1 um ein weiteres diesem virtuellen Feldgerät entsprechendes reales Feldgerät erweitert werden kann. Dem Anwender wird dazu stets angezeigt, wie die aktuelle Kommunikations- und Steuer-Belastung ist, sodass die Automatisierungseinrichtung 1 quasi in "homöopathischen Dosen" an die Kommunikations-und Steuer-Lastgrenzen herangeführt werden kann.

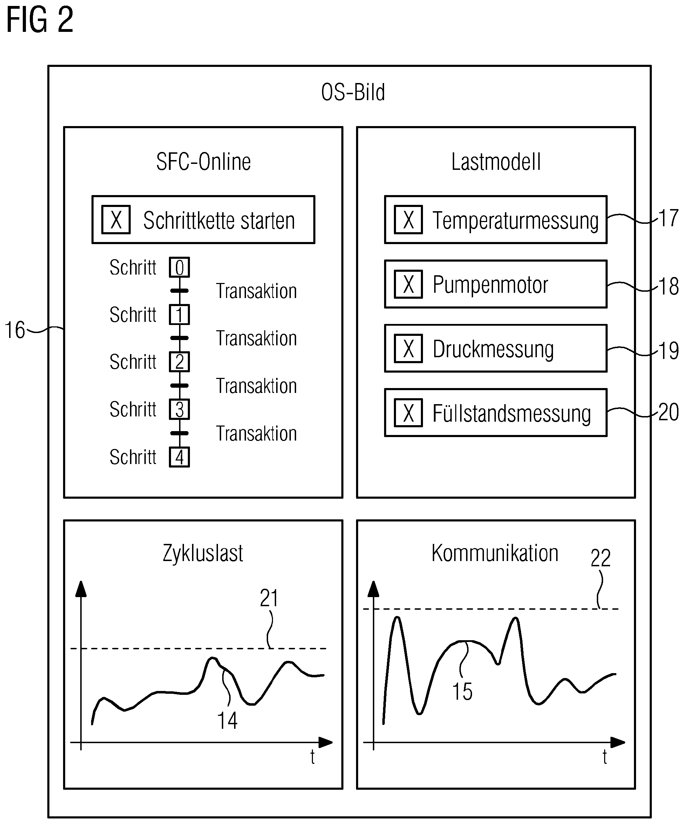

Im Folgenden wird auf Figur 2 verwiesen, in welcher die aktuelle Steuer-Belastung 14 sowie die aktuelle Kommunikations-Belastung 15 einer Automatisierungseinrichtung auf einem OS-Client dargestellt ist. Mittels den jeweiligen durch den Anwender aktivierbaren Schritten einer (SFC-)Schrittkette 16 erhöht der Anwender stufenweise die Steuer-Belastung eines Automatisierungsgerätes der Automatisierungseinrichtung sowie die Kommunikations-Belastung der Automatisierungseinrichtung, wobei der Anwender erkennt, dass im Rahmen des "stufenweisen" Hochfahrens der Last bzw. Zuschaltens von vier virtuellen Feldgeräten 17, 18, 19, 20 während der Prozesssteuerung bzw. der Verarbeitung eines Steuerprogramms die Steuer-Belastung 14 immer noch unterhalb einer Steuer-Lastgrenze 21 und die Kommunikations-Belastung 15 immer noch unterhalb der Kommunikations-Lastgrenze 22 liegt. Dies bedeutet, dass an die Automatisierungseinrichtung vier reale Feldgeräte, die durch die vier virtuellen Feldgeräte emuliert wurden, angeschlossen werden kann, ohne dass die Automatisierungseinrichtung um ein weiteres Automatisierungsgerät und weitere Kommunikationsmittel erweitert werden muss.

## Patentansprüche

1. Verfahren zum Erweitern einer Automatisierungseinrichtung (1) mit mindestens einem Feldgerät (9), wobei die Automatisierungseinrichtung (1)
- zumindest ein Automatisierungsgerät (2) und zumindest ein Feldgerät (9) aufweist, die an eine Kommunikationsverbindung (7, 8) angeschlossen sind, und
- durch ein Engineeringverfahren zur Lösung einer Automatisierungsaufgabe derart projektiert ist, dass das zumindest eine Automatisierungsgerät (2) während einer Prozesssteuerung ein projektiertes Steuerprogramm (10) verarbeitet, das eine Vielzahl von Steuer-Bausteinen umfasst,
**dadurch gekennzeichnet, dass**
- mindestens ein ein reales Feldgerät (9r) repräsentierendes virtuelles Feldgerät (5v) und ein Steuer-Baustein (10s) zum Ansteuern des virtuellen Feldgeräts (5v) projektiert werden,
- die aktuelle Kommunikations-Belastung durch den Kommunikationsteilnehmer (5) ermittelt wird, welche die durch die Kommunikation der Prozesssteuerung und die durch die Kommunikation zwischen dem virtuellen Feldgerät (5v) und einem projektierten Erweiterungs-Baustein (11) des zumindest einen Automatisierungsgeräts (2) verursachte Belastung umfasst,
wobei der Erweiterungs-Baustein (11) den Steuer-Baustein (10s) zum Ansteuern des virtuellen Feldgeräts (5v) umfasst und eine Schnittstelle (12) zum Austauschen von Informationen zwischen dem Erweiterungs-Baustein (11) und einem Bedien- und Beobachtunggerät (3) aufweist,
- die aktuelle Steuer-Belastung des zumindest einen Automatisierungsgeräts (2) durch den Erweiterungs-Baustein 11) erfasst wird, welche die durch die Prozesssteuerung und die durch die Verarbeitung des projektierten Steuer-Bausteins (10s) verursachte Belastung umfasst, und
- in Abhängigkeit der aktuellen Kommunikations- und der aktuellen Steuer-Belastung der projektierte Steuer-Baustein (10s) in das Steuerprogramm (10) eingebunden wird, falls dieser Steuer-Baustein (10s) zum Anschließen des realen Feldgerätes (9r) an den Bus (7, 8) durch einen Anwender über das Bedien- und Beobachtunggerät (3) freigeschaltet wird, wobei dem Anwender die aktuelle Kommunikations- und Steuer-Belastung auf dem Bedien- und Beobachtungsgerät (3) angezeigt wird.

2. Automatisierungseinrichtung, welche
- zumindest ein Automatisierungsgerät (2) und zumindest ein Feldgerät (9) aufweist, die an eine Kommunikationsverbindung (7, 8) angeschlossen sind,
- durch ein Engineeringverfahren zur Lösung einer Automatisierungsaufgabe derart projektiert ist, dass das zumindest eine Automatisierungsgerät (2) während einer Prozesssteuerung ein projektiertes Steuerprogramm (10) verarbeitet, das eine Vielzahl von Steuer-Bausteinen umfasst,
**dadurch gekennzeichnet, dass**
- in einem an die Kommunikationsverbindung (7, 8) angeschlossenen projektierten Kommunikationsteilnehmer (5) mindestens ein projektiertes virtuelles Feldgerät (5v) hinterlegt ist, das ein reales Feldgerät (9r) repräsentiert,
- der Kommunikationsteilnehmer (5) die aktuelle Kommunikations-Belastung ermittelt, welche die durch die Kommunikation der Prozesssteuerung und die durch die Kommunikation zwischen dem virtuellen Feldgerät (5v) und einem projektierten Erweiterungs-Baustein (11) des zumindest einen Automatisierungsgeräts (2) verursachte Belastung umfasst, wobei der Erweiterungs-Baustein (11) eine Schnittstelle (12) zum Austauschen von Informationen zwischen dem Erweiterungs-Baustein (11) und einem Bedien- und Beobachtunggerät (3) aufweist,
- ein projektierter Steuer-Baustein (10s) zum Ansteuern des virtuellen Feldgeräts (5v) im Erweiterungs-Baustein (11) hinterlegt ist,
- der Erweiterungs-Baustein (11) die aktuelle Steuer-Belastung des zumindest einen Automatisierungsgeräts (2) erfasst, welche die durch die Prozesssteuerung und die durch die Verarbeitung des Steuer-Bausteins (10s) verursachte Belastung umfasst, und
- der Erweiterungs-Baustein (11) dazu ausgebildet ist, in Abhängigkeit der aktuellen Kommunikations- und der aktuellen Steuer-Belastung den projektierten Steuer-Baustein (10s) in das Steuerprogramm (10) einzubinden, falls ein Anwender diesen Steuer-Baustein (10s) zum Anschließen des realen Feldgerätes (9r) an den Bus (7, 8) über das Bedien- und Beobachtunggerät (3) freischaltet, wobei dem Anwender die aktuelle Kommunikations- und Steuer-Belastung auf dem Bedienund Beobachtungsgerät (3) angezeigt wird.

## Claims

1. Method for expanding an automation facility (1) with at least one field device (9), wherein the automation facility (1)
- has at least one automation device (2) and at least one field device (9), which are connected to a communication link (7, 8), and
- is planned into a project by an engineering method for solving an automation problem such that the at least one automation device (2) processes a projected control program (10) that comprises a plurality of control modules when controlling a process,
**characterised in that**
- at least one virtual field device (5v) representing a real field device (9r) and a control module (10s) for controlling the virtual field device (5v) are planned into the project,
- the current communication load is determined by the communication user (5), which communication load comprises the load caused by the communication of the process control and the load caused by the communication between the virtual field device (5v) and an expansion module (11) of the at least one automation device (2) planned into the project, wherein the expansion module (11) comprises the control module (10s) for controlling the virtual field device (5v) and has an interface (12) for exchange of information between the expansion module (11) and a control and monitoring device (3),
- the current control load of the at least one automation device (2) is detected by the expansion module (11), which comprises the load caused by the process control and the load caused by the processing of the control module (10s) planned into the project, and
- the control module (10s) planned into the project is linked into the control program (10) as a function of the current communication load and the current control load, if this control module (10s) is enabled by a user for connecting the real field device (9r) to the bus (7, 8) via the control and monitoring device (3), wherein the current communication and control load is displayed to the user on the operator control and monitoring device (3).

2. Automation facility, which
- has at least one automation device (2) and at least one field device (9), which are connected to a communication link (7, 8),
- is planned into a project by an engineering method for solving an automation problem such that the at least one automation device (2), when controlling a process, processes a control program (10) planned into the project that comprises a plurality of control modules,
**characterised in that**
- at least one projected virtual field device (5v), which represents a real field device (9r) is stored in a projected communication user (5) connected to the communication link (7, 8),
- the communication user (5) determines the current communication load, which comprises the load caused by the communication of the process control and the load caused by the communication between the virtual field device (5v) and a projected expansion module (11) of the at least one automation device (2),
wherein the expansion module (11) has an interface (12) for exchange of information between the expansion module (11) and a control and monitoring device (3),
- a projected control module (10s) for controlling the virtual field device (5v) is stored in the expansion module (11),
- the expansion module (11) detects the current control load of the at least one automation device (2), which comprises the load caused by the process control and the load caused by the processing of the control module (10s), and
- the expansion module (11) is embodied to link the projected control module (10s) into the control program (10) as a function of the current communication load and the current control load, if a user enables this control module (10s) for connecting the real field device (9r) to the bus (7, 8) via the control and monitoring device (3), wherein the current communication and control load is displayed to the user on the operator control and monitoring device (3).

## Revendications

1. Procédé d'extension d'un dispositif (1) d'automatisation par au moins un appareil (9) sur site, le dispositif (1) d'automatisation
- ayant au moins un appareil (2) d'automatisation et au moins un appareil (9) sur site, qui sont raccordés à une liaison (7, 8) de communication, et
- étant en mis en projet par un procédé d'ingénierie pour résoudre une tâche d'automatisation, de manière à ce que le au moins un appareil (2) d'automatisation traite, pendant une commande de processus, un programme (10) de commande en projet, qui comprend une pluralité de modules de commande,
**caractérisé en ce que**
- on met en projet au moins un appareil (5v) sur site virtuel, représentant un appareil (9r) sur site réel, et un module (10s) de commande pour commander l'appareil (5v) sur site virtuel,
- on détermine la charge de communication en cours par le participant (5) à la communication, qui comprend la charge provoquée par la communication de la commande de processus et celle provoquée par la communication entre l'appareil (5v) sur site virtuel et un module (11) d'extension en projet du au moins un appareil (2) d'automatisation,
le module (11) d'extension comprenant le module (10s) de commande pour commander l'appareil (5v) sur site virtuel et ayant une interface (12) pour échanger des informations entre le module (11) d'extension et un appareil (3) de commande et d'observation,
- on relève la charge de commande en cours du au moins un appareil (2) d'automatisation par le module (11) d'extension, laquelle comprend la charge provoquée par la commande de processus et celle provoquée par le traitement du module (10s) de commande en projet, et
- en fonction de la charge de communication en cours et de la charge de commande en cours, on incorpore le module (10s) de commande en projet dans le programme (10) de commande, si ce module (10s) de commande est libéré pour le raccordement de l'appareil (9r) sur site réel au bus (7, 8) par un utilisateur, par l'intermédiaire de l'appareil (3) de commande et d'observation, la charge en cours de communication et de commande étant indiquée à l'utilisateur sur l'appareil (3) de commande et d'observation.

2. Dispositif d'automatisation, qui
- a au moins un appareil (2) d'automatisation et au moins un appareil (9) sur site, qui sont raccordés à une liaison (7, 8) de communication,
- est mis en projet par un procédé d'ingénierie pour résoudre une tâche d'automatisation, de manière à ce que le au moins un appareil (2) d'automatisation traite, pendant une commande de processus, un programme (10) de commande en projet, qui comprend une pluralité de modules de commande,
**caractérisé en ce que**
- dans un participant (5) à la communication en projet et raccordé à la liaison (7, 8) de communication est mis en mémoire au moins un appareil (5v) sur site virtuel en projet, qui représente un appareil (9r) sur site réel,
- le participant (5) à la communication détermine la charge de communication en cours, qui comprend la charge provoquée par la communication entre l'appareil (5v) sur site virtuel et un module (11) d'extension en projet du au moins un appareil (2 ) d'automatisation, le module (11) d'extension ayant une interface (12) pour échanger des informations entre le module (11) d'extension et un appareil (3) de commande et d'observation,
- un module (10s) de commande en projet pour commander l'appareil (5v) sur site virtuel est mis dans le module (11) d'extension,
- le module (11) d'extension relève la charge de commande en cours du au moins un appareil (2) d'automatisation, qui comprend la charge provoquée par la commande de processus et celle provoquée par le traitement du module (10s) de commande, et
- le module (11) d'extension est constitué pour incorporer, en fonction de la charge de communication en cours et de la charge de commande en cours, le module (10s) de commande en projet dans le programme (10) de commande, si un utilisateur libère ce module (10s) de commande pour le raccordement de l'appareil (9r) sur site réel au bus (7, 8) par l'intermédiaire de l'appareil (3) de commande et d'observation, la charge en cours de communication et de commande étant indiquée à l'utilisateur sur l'appareil (3) de commande et d'observation.
